# EUROPEAN PATENT SPECIFICATION

(11) **EP 2 495 349 B1**
(45) Date of publication and mention of the grant of the patent: **11.12.2013**
(21) Application number: 11157010.7
(22) Date of filing: 04.03.2011
(51) Int. Cl.: C23C 16/455, C23C 16/40, C23C 16/453

(54) **Method for depositing a coating on a substrate by chemical vapour deposition**
Verfahren zum Ablagern einer Beschichtung auf einem Substrat durch chemische Dampfablagerung
Procédé de dépôt d'un revêtement sur un substrat par dépôt de vapeur chimique

(43) Date of publication of application: 05.09.2012
(73) Proprietor: Onderzoekscentrum voor Aanwending van Staal N.V., 9060 Zelzate (BE)
(72) Inventor: Siau, Sam, B-2370, ARENDONK (BE); Horzenberger, Franz, B-9960, ASSENEDE (BE); De Sloover, Kurt, B-8470, GISTEL (BE)
(74) Representative: Pronovem

(56) References cited:
- EP-A1- 1 602 633
- WO-A2-01/02622
- WO-A2-2006/061785
- WO-A2-2009/114851
- DE-A1-102004 029 911
- US-A1- 2009 092 843

## Description

### Field of the Invention

The present invention is related to methods for depositing an inorganic coating on a substrate via chemical vapour deposition (CVD), in particular by flame assisted CVD (FACVD) or Combustion CVD (CCVD).

### State of the art

FACVD and CCVD are variants of CVD that involve the combustion of liquid or gaseous precursors injected and/or delivered into diffused or premixed flames where the precursor will decompose/vaporize and undergo a chemical reaction/combustion in the flame. CCVD is in fact an FACVD-based method. Both techniques are described in Progress in Materials Science 48(2003), pp. 140-144.

The possibility of combining atmospheric pressure and low temperature during processing makes FACVD/CCVD a useful technique for various applications in which high throughput coating is required.

However, processing speeds have so far been limited due to a deterioration of coating quality and/or coating thickness at high relative substrate speeds, i.e. speed of the substrate relative to the flame. In particular, at speeds above 30m/min, current FACVD/CCVD techniques do not allow to obtain coatings with sufficient quality, as assessed by the obtainable coating thickness and by a carbon black test in combination with a colour measurement.

In the case of heat sensitive surfaces, such as painted metal sheets, polymer substrates such as polycarbonate substrates, or other materials such as glass or textiles, it has been found to be difficult to obtain good quality coatings by FACVD due to the material itself being destroyed by the high temperatures, or due to undesired chemical or physical reactions/transformations taking place just underneath the outermost surface of the substrate, causing damage in terms of coating adhesion, durability etc.

DE102004029911A1 discloses a method for successfully depositing Ti-oxide and Si-oxide, by not directly injecting the precursor into the flame, but by providing the precursor flow in the vicinity of two FACVD burners. The process speed of this process is however also limited to 30m/min.

### Aims of the invention

The present invention aims to provide an FACVD/CCVD method capable of obtaining good inorganic coating quality on heat-sensitive materials.

### Summary of the invention

The invention is related to a method as disclosed in the appended claims. The invention is thus related to a method for depositing a coating on a substrate by a flame-assisted chemical vapour deposition technique, wherein the substrate is exposed to a flame produced by a burner, while a flow of precursor elements is added to said flame, and wherein the substrate is subjected to a relative movement with respect to said burner, wherein the substrate comprises on its surface or consists of a heat sensitive material, wherein the coating deposition takes place in two or more deposition steps on a optionally pre-heated substrate, each deposition step consisting of a number of subsequent passes on the same portion of the substrate, each pass consisting of a movement of the substrate relative to the flame at a speed of 30m/min or more, no external cooling being applied during said movement, and wherein after each deposition step, the substrate is subjected to a cooling step, wherein the substrate cools down to its initial temperature.

According to an embodiment, the substrate is removed from the flame after each step, during a period sufficiently long to let the substrate cool down under ambient air to its initial temperature. According to another embodiment, the substrate is removed from the flame after each step and cooled down to its initial temperature by forced cooling.

According to preferred embodiments, said heat sensitive material is polypropylene (PP), polyvinylchloride (PVC) or Acrylonitrile Butadiene Styrene (ABS).

According to an embodiment, said heat-sensitive material is PP, and
- the relative speed between the flame and the substrate is between 80m/min and 200m/min,
- each step comprises two or three passes,
- the cooling time between steps is at least 2 minutes,
- the substrate is preheated to a temperature between 40°C and 75°C.

According to another embodiment, said heat-sensitive material is PVC, and:
- the relative speed between the flame and the substrate is between 60m/min and 80m/min,
- each step comprises two or three passes,
- the cooling time between steps is at least 10 minutes,
- the substrate is not pre-heated.

According to another embodiment, said heat-sensitive material is ABS, and:
- the relative speed between the flame and the substrate is between 80m/min and 200m/min,
- each step comprises two or three passes,
- the cooling time between steps is at least 10 minutes,
- the substrate is not pre-heated.

According to an embodiment, the following parameters are applied in combination with any of the above:
- the precursor flow is between 200µl/min and 600µl/min,
- the ratio of the precursor flow relative to the burner gas flow (fuel gas + air) is between 0.9X10⁻⁶ and 2.8X10⁻⁶ (liter_{precursor}/liter_{gas}) ,
- the distance burner substrate is between 10mm and 15mm.

The number of steps may be 3 or 4. According to a preferred embodiment, the precursor elements are configured to produce a silicon oxide coating. Said precursor may be HMDSO.

### Brief description of the figures

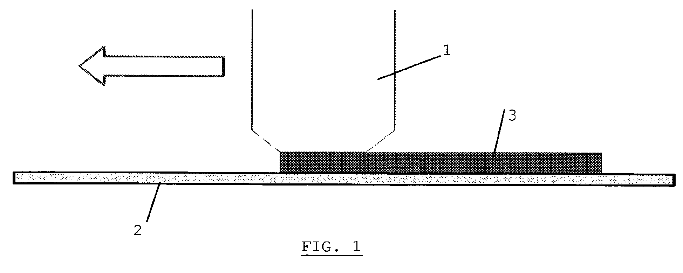

Figure 1 shows a schematic view of an FACVD setup according to the invention.

### Detailed description of the invention

The inventors of the present invention have found that in particular on heat-sensitive materials such as described above, good coating quality in terms of thickness and carbon black/colour measurements can be obtained by FACVD, by increasing the relative substrate speed to values above 30m/min. According to a more preferred embodiment, the relative substrate speed is above 40m/min. According to a further preferred embodiment, the relative substrate speed is above 50m/min. At these high speeds, a 'drag effect' takes place of the substrate on the flame, as illustrated in figure 1. The arrow shows the relative speed of the FACVD head 1 with respect to the substrate 2. At high relative speeds, the flame extends over a reaction zone 3 behind the FACVD head. It has been found that this effect reduces the heat flow towards the substrate, whilst still providing sufficient heat for the precursor elements to react and form a coating. The reduced heat flow avoids the undesired chemical and physical reaction taking place underneath the substrate surface. The FACVD method of the invention can take place at near-atmospheric, atmospheric or higher pressure.

The present invention has established preferred ranges for a number of process parameters, as well as conditions in terms of cooling the substrate, which allow for the above described drag effect to take place so that a high quality coating is obtained at relative substrate speeds above 30m/min. In scientific terms, it is necessary to maintain the dynamic temperature between given limits. The dynamic temperature is defined as the temperature at each instantaneous moment in time during the deposition process for a small material element of the substrate material. The dynamic temperature is a function of the flows of entropy and energy (mainly defined by temperature and precursor reactions) in the thermodynamic system defined by the reaction zone. According to preferred embodiments, conditions for obtaining a good coating are also related to the external cooling applied to the substrate. According to preferred embodiments, no external cooling is applied or an intermittent air cooling is applied, instead of a continuous cooling by a water bath or heat sink, which is applied in prior art methods. Also, preferred ranges have been established for a number of process parameters, in particular the precursor flow relative to the flow of burner gases, and the pre-heating temperature of the substrate.

Instead of the set-up of figure 1, it is also possible to coat the substrate by reversing the setup of figure 1, i.e. by supplying the flame and precursor flow upwards towards a substrate moving with respect to the flame above said flame. It is also possible to move the substrate in a vertical plane and supply the flame and precursor horizontally.

Previous test results prove that the higher process speeds result in an increasing 'cooling effect', that is beneficial for a good coating formation, to the degree that external cooling becomes less and less necessary, to the point of being not needed. Together with the 'drag effect', this results in the formation of high quality coatings on materials which could not so far be coated by FACVD.

The present invention reveals process parameters to be applied for depositing a coating by FACVD on a substrate consisting of or comprising on its surface a heat sensitive material. In the context of the present invention, a 'heat-sensitive material' is defined as a material which cannot be coated by FACVD when the relative substrate speed is lower than 30m/min and when no external cooling is applied. External cooling is here defined as a forced cooling, i.e. an active effort to cool down the substrate, in addition to the cooling down of the substrate through contact with the ambient air. So when 'no external cooling' is applied, this means that the substrate cools down only by contact with the ambient.

According to the invention, two or more deposition passes are done on the same portion of the substrate, without any external cooling of the substrate during the deposition, after which the substrate is left to cool down to its initial temperature (room temperature or a preheating temperature). Alternatively, the substrate is cooled down to its initial temperature by forced cooling (for example forced air cooling or water cooling) in between the steps. One pass is defined as a continuous movement of an FACVD head relative to the substrate or vice versa. This can be a movable FACVD head moving linearly over a flat substrate, or a substrate mounted onto a rotating cylinder, moving underneath a stationary FACVD head. A sequence of such passes is hereafter called a deposition step. The method comprises two or more deposition steps, with a cooling step (cooling down under ambient or forced cooling) in between deposition steps and after the last deposition step. According to the invention, each pass is performed at a relative speed between the FACVD head and the substrate of more than 30m/min, preferably more than 40m/min, more preferably more than 50m/min. The maximum speed depends on the type of substrate and coating applied.

Preferred specific process parameters are given hereafter for the cases where the heat sensitive material is Poly Vinyl Chloride (PVC), Acrylonitrile Butadiene Styrene (ABS) or polypropylene (PP).

For PP, the following conditions are preferred :
- relative speed between burner and substrate : between 80m/min and 200m/min coating in a number of deposition steps of two or three passes in each step, with a cooling time under ambient air of at least 10min between steps,
- pre-heating the substrate before coating to a preheating temperature between 40° and 75°C.
According to a preferred embodiment, the number of steps applied on PP is 3 or 4. According to a further preferred embodiment, the distance substrate-burner is 1cm.

For PVC, the following conditions are preferred :
- relative speed between burner and substrate : between 60m/min and 80m/min,
- coating in a number of deposition steps of two or three passes in each step, with a cooling time under ambient air of at least 10min between steps.
- no pre-heating
According to a preferred embodiment, the number of steps applied on PVC is 3 or 4. According to a further preferred embodiment, the distance substrate-burner is 1,5cm.

For ABS, the following conditions are preferred :
- relative speed between burner and substrate : between 80m/min and 200m/min,
- coating in a number of deposition steps of two or three passes in each step, with a cooling time under ambient air of at least 10min between steps,
- no pre-heating.
According to a preferred embodiment, the number of steps applied on ABS is 3 or 4. According to a further preferred embodiment, the distance substrate-burner is 1,5cm.

Apart from the above, the following process parameters are preferred for all three materials:
- 200-600µl/min precursor flow,
- ratio precursor flow/burner gas flow (fuel gas + air) between 0.9X10⁻⁶ and 2.8X10⁻⁶ (liter_{precursor}/liter_{gas}) , note: precursor is liquid phase and gasses gas phase
- distance between the burner and the substrate between 10mm and 15mm.

For example, the precursor flow can be a HMDSO flow of 400µl/min, the FACVD burner can be fuelled by a propane flow of 9.1L/min, and an air flow of 2001/min (burner gas flow is 209.1L/min, ratio is 1.9X10⁻⁶) .

According to preferred embodiments, the precursor that is used in the invention is suitable for forming a silicon-oxide coating on the surface. A preferred precursor is hexamethyldisiloxane (HMDSO) : applied under the above conditions, this precursor allows to produce a coating on all three materials PP, PVC and ABS with good easy-to-clean properties.

## Claims

1. A method for depositing a coating on a substrate (2) by a flame-assisted chemical vapour deposition technique, wherein the substrate is exposed to a flame produced by a burner (1), while a flow of precursor elements is added to said flame, and wherein the substrate is subjected to a relative movement with respect to said burner, wherein the substrate comprises on its surface or consists of a heat sensitive material, wherein the coating deposition takes place in two or more deposition steps on a optionally pre-heated substrate, each deposition step consisting of a number of subsequent passes on the same portion of the substrate, each pass consisting of a movement of the substrate relative to the flame at a speed of 30m/min or more, no external cooling being applied during said movement, and wherein after each deposition step, the substrate is subjected to a cooling step, wherein the substrate cools down to its initial temperature.

2. Method according to claim 1, wherein the substrate is removed from the flame after each step, during a period sufficiently long to let the substrate cool down under ambient air to its initial temperature.

3. Method according to claim 1 wherein the substrate is removed from the flame after each step and cooled down to its initial temperature by forced cooling.

4. Method according to any one of claims 1 to 3, wherein said heat sensitive material is polypropylene (PP), polyvinylchloride (PVC) or Acrylonitrile Butadiene Styrene (ABS).

5. Method according to claim 4, wherein said heat-sensitive material is PP, and wherein
• the relative speed between the flame and the substrate is between 80m/min and 200m/min,
• each step comprises two or three passes,
• the cooling time between steps is at least 2 minutes,
• the substrate is preheated to a temperature between 40°C and 75°C.

6. Method according to claim 4, wherein said heat-sensitive material is PVC, and wherein :
• the relative speed between the flame and the substrate is between 60m/min and 80m/min,
• each step comprises two or three passes,
• the cooling time between steps is at least 10 minutes,
• the substrate is not pre-heated.

7. Method according to claim 4, wherein said heat-sensitive material is ABS, and wherein :
• the relative speed between the flame and the substrate is between 80m/min and 200m/min,
• each step comprises two or three passes,
• the cooling time between steps is at least 10 minutes,
• the substrate is not pre-heated.

8. Method according to any one of the preceding claims, wherein
• the precursor flow is between 200µl/min and 600µl/min,
• the ratio of the precursor flow relative to the burner gas flow (fuel gas + air) is between 0.9X10⁻⁶ and 2.8X10⁻⁶ (liter_{precursor}/liter_{gas}),
• the distance burner substrate is between 10mm and 15mm.

9. Method according to any one of the preceding claims, wherein the number of steps is 3 or 4.

10. Method according to any one of the preceding claims, wherein the precursor elements are configured to produce a silicon oxide coating.

11. Method according to claim 10, wherein said precursor is HMDSO.

## Patentansprüche

1. Verfahren zur Ablage einer Beschichtung auf einem Substrat (2) durch eine flammengestützte, chemische Dampfablagetechnik, wobei das Substrat einer Flamme ausgesetzt wird, die von einem Brenner (1) produziert wird, während ein Fluss von Vorläuferelementen zur genannten Flamme hinzugefügt wird und wobei das Substrat einer relativen Bewegung bezüglich des genannten Brenners ausgesetzt wird, wobei das Substrat an seiner Oberfläche ein wärmeempfindliches Material umfasst oder aus diesem besteht, wobei die Beschichtungsablage in zwei oder mehr Ablageschritten auf einem optional vorgewärmten Substrat erfolgt, wobei jeder Ablageschritt jeweils aus einer Reihe von aufeinanderfolgenden Durchläufen am selben Abschnitt des Substrats besteht, wobei jeder Durchlauf aus einer Bewegung des Substrats relativ zu Flamme bei einer Geschwindigkeit von 30 m/min oder mehr besteht, keine externe Kühlung während der genannten Bewegung angewendet wird und wobei das Substrat nach jedem Ablageschritt einem Kühlungsschritt ausgesetzt wird, wobei das Substrat auf seine Anfangstemperatur abkühlt.

2. Verfahren nach Anspruch 1, wobei das Substrat nach jedem Schritt von der Flamme innerhalb eines Zeitraumes entfernt wird, der ausreichend lang ist, um das Substrat in Raumluft auf seine Anfangstemperatur abkühlen zu lassen.

3. Verfahren nach Anspruch 1, wobei das Substrat nach jedem Schritt von der Flamme entfernt und auf seine Anfangstemperatur durch Zwangskühlung abgekühlt wird.

4. Verfahren nach einem der Ansprüche 1 bis 3, wobei das genannte wärmeempfindliche Material Polypropylen (PP), Polyvinylchlorid (PVC) oder Acrylnitrilbutadienstyrol (ABS) ist.

5. Verfahren nach Anspruch 4, wobei das genannte wärmeempfindliche Material PP ist und wobei
• die relative Geschwindigkeit zwischen der Flamme und dem Substrat zwischen 80 m/min und 200 m/min beträgt,
• jeder Schritt zwei oder drei Phasen umfasst,
• die Abkühlungszeit zwischen den Schritten wenigstens 2 Minuten beträgt,
• das Substrat auf eine Temperatur von zwischen 40 °C und 75 °C vorgewärmt wird.

6. Verfahren nach Anspruch 4, wobei das genannte wärmeempfindliche Material PVC ist und wobei:
• die relative Geschwindigkeit zwischen der Flamme und dem Substrat zwischen 60 m/min und 80 m/min beträgt,
• jeder Schritt zwei oder drei Phasen umfasst,
• die Abkühlungszeit zwischen den Schritten wenigstens 10 Minuten beträgt,
• das Substrat nicht vorgewärmt wird.

7. Verfahren nach Anspruch 4, wobei das genannte wärmeempfindliche Material ABS ist und wobei:
• die relative Geschwindigkeit zwischen der Flamme und dem Substrat zwischen 80 m/min und 200 m/min beträgt,
• jeder Schritt zwei oder drei Phasen umfasst,
• die Abkühlungszeit zwischen den Schritten wenigstens 10 Minuten beträgt,
• das Substrat nicht vorgewärmt wird.

8. Verfahren nach einem der vorstehenden Ansprüche, wobei
• der Vorläuferfluss zwischen 200 µl/min und 600 µl/min beträgt,
• das Verhältnis des Vorläuferflusses relativ zum Brennergasfluss (Brennstoffgas + Luft) zwischen 0,9X10⁻⁶ und 2,8X10⁻⁶ (Liter_{Vorläufer}/Liter_{Gas}) beträgt,
• der Abstand zwischen Brenner und Substrat zwischen 10 mm und 15 mm beträgt.

9. Verfahren nach einem der vorstehenden Ansprüche, wobei die Anzahl der Schritte 3 oder 4 beträgt.

10. Verfahren nach einem der vorstehenden Ansprüche, wobei die Vorläuferelemente derart konfiguriert sind, um eine Silikonoxidbeschichtung zu produzieren.

11. Verfahren nach Anspruch 10, bei der genannte Vorläufer HMDSO ist.

## Revendications

1. Procédé de dépôt d'un revêtement sur un substrat (2) par une technique de dépôt chimique en phase vapeur assistée par flamme, dans lequel le substrat est exposé à une flamme produite par un brûleur (1), tandis qu'un écoulement d'éléments de précurseur est ajouté à ladite flamme, et dans lequel le substrat est soumis à un mouvement relatif par rapport audit brûleur, dans lequel le substrat comprend sur sa surface ou consiste en une matière thermosensible, dans lequel le dépôt du revêtement a lieu en deux ou plusieurs étapes de dépôt sur un substrat facultativement préchauffé, chaque étape de dépôt consistant en un nombre de passes consécutives sur la même partie du substrat, chaque passe consistant en un mouvement du substrat par rapport à la flamme à une vitesse de 30 m/min ou plus, aucun refroidissement externe n'étant appliqué pendant ledit mouvement, et dans lequel, après chaque étape de dépôt, le substrat est soumis à une étape de refroidissement dans laquelle le substrat refroidit jusqu'à sa température initiale.

2. Procédé selon la revendication 1, dans lequel le substrat est retiré de la flamme après chaque étape, pendant une période suffisamment longue pour laisser le substrat refroidir sous air ambiant jusqu'à sa température initiale.

3. Procédé selon la revendication 1, dans lequel le substrat est retiré de la flamme après chaque étape et refroidi jusqu'à sa température initiale par refroidissement forcé.

4. Procédé selon l'une quelconque des revendications 1 à 3, dans lequel ladite matière thermosensible est le polypropylène (PP), le polychlorure de vinyle (PVC) ou l'acrylonitrile butadiène styrène (ABS).

5. Procédé selon la revendication 4, dans lequel ladite matière thermosensible est le PP, et dans lequel :
• la vitesse relative entre la flamme et le substrat est entre 80 m/min et 200 m/min ;
• chaque étape comprend deux ou trois passes ;
• le temps de refroidissement entre les étapes est d'au moins 2 minutes ;
• le substrat est préchauffé à une température entre 40°C et 75°C.

6. Procédé selon la revendication 4, dans lequel ladite matière thermosensible est le PVC, et dans lequel :
• la vitesse relative entre la flamme et le substrat est entre 60 m/min et 80 m/min ;
• chaque étape comprend deux ou trois passes ;
• le temps de refroidissement entre les étapes est d'au moins 10 minutes ;
• le substrat n'est pas préchauffé.

7. Procédé selon la revendication 4, dans lequel ladite matière thermosensible est l'ABS, et dans lequel :
• la vitesse relative entre la flamme et le substrat est entre 80 m/min et 200 m/min ;
• chaque étape comprend deux ou trois passes ;
• le temps de refroidissement entre les étapes est d'au moins 10 minutes ;
• le substrat n'est pas préchauffé.

8. Procédé selon l'une quelconque des revendications précédentes, dans lequel :
• l'écoulement de précurseur est entre 200 µl/min et 600 µl/min ;
• le rapport de l'écoulement de précurseur par rapport à l'écoulement de gaz du brûleur (gaz combustible + air) est entre 0,9 x 10⁻⁶ et 2,8 x 10⁻⁶ (litre _{précurseur}/litre_{gaz}) ;
• la distance brûleur substrat est entre 10 mm et 15 mm.

9. Procédé selon l'une quelconque des revendications précédentes, dans lequel le nombre d'étapes est 3 ou 4.

10. Procédé selon l'une quelconque des revendications précédentes, dans lequel les éléments de précurseur sont configurés pour produire un revêtement d'oxyde de silicium.

11. Procédé selon la revendication 10, dans lequel ledit précurseur est le HMDSO.
